# DEMANDE DE BREVET EUROPEEN

(11) **EP 1 691 373 A1**
(43) Date de publication de la demande: **16.08.2006**
(21) Numéro de dépôt: 06290145.9
(22) Date de dépôt: 24.01.2006
(51) Int. Cl.: G11C 17/10, H01L 21/8246

(54) **Dispositif semi-conducteur de mémoire morte et procédé de programmation correspondant**

(30) Priorité: 02.02.2005 FR 0501007
(71) Demandeur: STMicroelectronics SA, F-92120 Montrouge (FR)
(72) Inventeur: Schoellkopf, Jean-Pierre, 38000 Grenoble (FR)
(74) Mandataire: Zapalowicz, Francis

(57) **Abrégé**

Une cellule semi-conductrice comporte au sein d'une région de substrat quatre zones actives (Z1-Z4) mutuellement isolées latéralement, la première zone active étant destinée à être reliée à une première tension (VDD), la deuxième zone active, d'un type de conductivité opposé à celui de la première zone active, étant destinée à être reliée à une deuxième tension (GND), les troisième et quatrième zones actives (Z3-Z4) étant mutuellement reliées par une connexion de raccordement (P34) électriquement conductrice et extérieure au substrat. On définit la valeur de l'information binaire par une implantation de type choisi dans une partie (CSA) prédéterminée de la région de substrat (SB) ou dans les troisième et quatrième zones actives (Z3-Z4).

## Description

L'invention concerne les mémoires, plus particulièrement les mémoires mortes (mémoires ROM), ou plus généralement mais non limitativement un élément de mémorisation d'information binaire qui a une valeur fixée au moment de la fabrication d'un circuit intégré et ne peut être que lue par la suite, et en pratique un circuit intégré comportant un ensemble de tels éléments de mémorisation.

Un but de l'invention est de proposer un dispositif semi-conducteur de mémoires simple à réaliser, présentant une bonne densité, et offrant un coût de fabrication réduit voire faible.

Un autre but de l'invention est de proposer un dispositif qui puisse être programmé de façon flexible à la demande de l'utilisateur.

L'invention a encore pour but de proposer un dispositif de mémoire ayant une structure rendant difficilement détectable de l'extérieur (sauf bien entendu à procéder à une lecture de la mémoire ou bien à une analyse de sa structure interne) le contenu des informations binaires qui y sont stockées.

Selon un premier aspect de l'invention, il est proposé un dispositif de mémoire comprenant au moins une cellule, et en pratique un ensemble de cellules. Chaque cellule stocke une information binaire et comporte au sein d'une région semi-conductrice de substrat, par exemple un substrat de type P, quatre zones actives mutuellement isolées latéralement. La première zone active est destinée à être reliée à une première tension, et la deuxième zone active, d'un type de conductivité opposé à celui de la première zone active, est destinée à être reliée à une deuxième tension.

La première tension est à titre indicatif généralement une tension dite tension d'alimentation du circuit (pouvant aller de 5Volts sur une technologie haute tension, à 1 Volt pour une technologie submicronique). La deuxième tension est à titre indicatif une tension de référence, généralement appelée la masse

Les troisième et quatrième zones actives sont mutuellement reliées par une connexion de raccordement électriquement conductrice extérieure au substrat, par exemple par l'intermédiaire de deux contacts et d'un fil métallique.

La cellule semi-conductrice comporte par ailleurs des moyens semi-conducteurs dits « de liaison électrique », internes au substrat, et agencés de façon à relier électriquement au moins l'une ou l'autre des troisième et quatrième zones actives à la première zone active ou bien à la deuxième zone active selon la valeur logique de ladite information binaire.

La cellule semi-conductrice comporte par ailleurs des moyens semi-conducteurs dits « d'isolation électrique », internes au substrat, aussi appelés par exemple « couches enterrées », et agencés de façon à isoler électriquement les troisième et quatrième zones actives de la deuxième zone active ou bien de la première zone active, respectivement.

Les moyens semi-conducteurs d'isolation électrique comportent par exemple des jonctions PN formant des diodes bloquées (ou polarisées en inverse) :
- entre au moins une zone active et la région de substrat, ou
- entre au moins une zone active et un caisson semi-conducteur situé dans la région de substrat, ce caisson semi-conducteur ayant un type de conductivité opposé à celui de la région de substrat et ayant une interface avec au moins cette zone active, et/ou
- entre ledit caisson et la région de substrat.

Par ailleurs, les moyens semi-conducteurs de liaison électrique comportent alors avantageusement la région de substrat ou ledit caisson.

Ainsi, selon cet aspect de l'invention, la programmation de la valeur logique 0 ou 1 d'une information binaire à stocker dans la cellule, dépend de l'agencement de la structure semi-conductrice de la cellule, ce qui va avoir pour conséquence lorsque les première et deuxième zones actives sont portées aux première et deuxième tensions, de porter la connexion de raccordement entre les troisième et quatrième zones actives soit à la première tension (par exemple la tension d'alimentation) soit à la deuxième tension (par exemple la masse) en fonction de cet agencement, c'est-à-dire en fonction de la valeur logique de l'information binaire.

Et, ces différents agencements de la structure semi-conductrice de la cellule s'effectuent avantageusement par implantation de type choisi dans une partie prédéterminée de la région de substrat ou dans les troisième et quatrième zones actives, ce qui rend par conséquent difficilement détectable de l'extérieur (sans procéder à une lecture effective de la mémoire ou bien à une analyse effective de la structure semi-conductrice enterrée de la cellule) la programmation de la cellule-mémoire.

Selon une première variante de l'invention, les troisième et quatrième zones actives ont respectivement deux types de conductivité opposés (N+ et P+). La cellule comporte ledit caisson ayant des interfaces avec les troisième et quatrième zones actives et avec celle des première ou deuxième zones actives ayant le même type de conductivité que celui du caisson, ou bien ne comporte pas un tel caisson.

Le fait que la cellule comporte ou ne comporte pas le caisson conditionne la valeur logique de l'information binaire stockée.

La première zone active, qui est destinée à être reliée à la première tension (par exemple la tension d'alimentation) est par exemple de type de conductivité N tandis que la deuxième zone active qui est destinée à être reliée à la deuxième tension (par exemple la masse) est de type de conductivité P. L'éventuel caisson a alors un type de conductivité N.

Dans une autre variante de l'invention, les troisième et quatrième zones actives ont toutes le deux le même type de conductivité (N ou P). La structure semi-conductrice d'une telle cellule comporte alors un caisson ayant une interface avec la troisième zone active et avec celle des première ou deuxième zones actives ayant le même type de conductivité que celui du caisson. Et, dans cette variante, c'est le type de conductivité (N ou P) des troisième et quatrième zones actives qui définit la valeur logique de l'information binaire.

En pratique, le dispositif comporte avantageusement un ensemble de cellules stockant un ensemble un ensemble d'informations binaires. Ainsi, le dispositif peut être une mémoire matricielle de cellules.

Le dispositif comprend également avantageusement des moyens de lecture de chaque cellule, ces moyens de lecture comportant une première source de tension connectée sur la première zone active, une deuxième source de tension connectée sur la deuxième zone active et des moyens de mesure de la tension présente sur ladite connexion de raccordement de ladite cellule.

Selon un autre aspect de l'invention, il est également proposé un procédé de lecture de la valeur logique d'une information binaire contenue dans une cellule d'un dispositif de mémoire tel que défini ci-avant. Selon cet autre aspect de l'invention, on applique la première tension (par exemple la tension d'alimentation) sur ladite première zone active, on applique la deuxième tension (par exemple la masse) sur ladite deuxième zone active et on mesure la tension sur ladite connexion de raccordement.

Selon encore un autre aspect de l'invention, il est également proposé un procédé de programmation d'une information binaire dans une cellule comportant au sein d'une région semi-conductrice de substrat quatre zones actives mutuellement isolées latéralement, la première zone active étant destinée à être reliée à une première tension, la deuxième zone active, d'un type de conductivité opposé à celui de la première zone active, étant destinée à être reliée à une deuxième tension, les troisième et quatrième zones actives étant mutuellement reliées par une connexion de raccordement électriquement conductrice extérieure au substrat. On définit alors la valeur de l'information binaire par une implantation de type choisi dans une partie prédéterminée de la région de substrat ou dans les troisième et quatrième zones actives.

Ainsi, selon une variante de l'invention dans laquelle les troisième et quatrième zones actives ont des types de conductivité opposés, on définit la valeur logique de l'information binaire en implantant ou non dans la région de substrat un caisson semi-conducteur ayant un type de conductivité opposé à celui de la région de substrat, et ayant des interfaces avec les troisième et quatrième zones actives et avec celle des première ou deuxième zones actives ayant le même type de conductivité que celui du caisson.

Selon une autre variante de l'invention, dans laquelle les troisième et quatrième zones actives ont toutes les deux le même type de conductivité, et dans laquelle on implante dans la région de substrat un caisson semi-conducteur ayant un type de conductivité opposé à celui de la région de substrat et ayant une interface avec la troisième zone active et avec celles des première et deuxième zones actives ayant le même type de conductivité que celui du caisson, on définit la valeur logique de ladite information binaire en choisissant le type d'implantation (N ou P) dans les troisième et quatrième zones actives.

Lorsque l'on souhaite programmer les valeurs d'un ensemble d'informations binaires respectivement contenues dans un ensemble de cellules semi-conductrices, on programme alors avantageusement chaque cellule avec un procédé tel que défini ci-avant.

Selon un mode de mise en oeuvre, compatible avec la variante de l'invention de l'invention dans laquelle on choisit la valeur logique de l'information binaire en implantant ou non un caisson dans la région de substrat, on définit les emplacements d'implantation des caissons éventuels de toutes les cellules de la mémoire par des orifices dans un masque d'implantation, par exemple en résine, et on implante simultanément tous les caissons à travers les orifices du masque.

Selon un autre mode de mise en oeuvre de l'invention, compatible avec la variante de l'invention dans laquelle on programme la valeur logique « 0 » ou « 1 » de l'information binaire en choisissant le type de conductivité (N ou P) des troisième et quatrième zones actives, on définit un masque d'implantation de type N+ et un masque d'implantation de type P+, et on implante simultanément toutes les zones actives de toutes les cellules à travers les orifices des masques d'implantation en utilisant successivement les deux masques d'implantation.

On peut définir les emplacements des orifices du ou des masques d'implantation par un masque de photolithographie et/ou par un faisceau d'électrons.

En d'autres termes, on peut définir les emplacements des orifices dans le masque de résine en utilisant un masque de photolithographie. Dans ce cas, on insole la résine à travers le masque de photolithographie. Une telle option rend la programmation difficilement flexible car une modification de la programmation d'un lot de dispositifs de mémoire à l'autre nécessiterait la réalisation d'un nouveau masque de lithographie.

A l'inverse, une autre possibilité consiste à insoler la résine par une technique bien connue de faisceau d'électrons (technique dite « E beam »). On peut alors décider au cas par cas, compte tenu de la programmation souhaitée pour le dispositif de mémoire, de l'emplacement des orifices dans le masque de résine. Une telle option offre donc une flexibilité maximale.

Une troisième option consiste à effectuer un mixage entre la photolithographie et le faisceau d'électrons. En d'autres termes, par exemple la programmation d'une partie du circuit intégré autre que la mémoire, ainsi que d'une partie de la mémoire serait « figée » par l'utilisation d'un masque de photolithographie tandis que l'autre partie de la mémoire pourrait être programmée de façon flexible en utilisant la technique d'insolation par faisceau d'électrons.

D'autres avantages et caractéristiques de l'invention apparaîtront à l'examen de la description détaillée de modes de réalisation et de mise en oeuvre, nullement limitatifs, et des dessins annexés, sur lesquels :
- les figures 1, 2 et 3 illustrent schématiquement un premier mode de réalisation d'un dispositif de mémoire selon l'invention,
- la figure 4 illustre schématiquement un exemple de moyens permettant la lecture d'une cellule d'un dispositif de mémoire selon l'invention,
- la figure 5 illustre schématiquement les principales étapes d'un mode de programmation selon l'invention compatible avec la variante illustrée sur les figures 1 à 3,
- les figures 6, 7 et 8 illustrent schématiquement un autre mode de réalisation d'un dispositif de mémoire selon l'invention, et,
- la figure 9 illustre un autre mode de mise en oeuvre d'une programmation selon l'invention compatible avec la variante illustrée selon les figures 6 à 8.

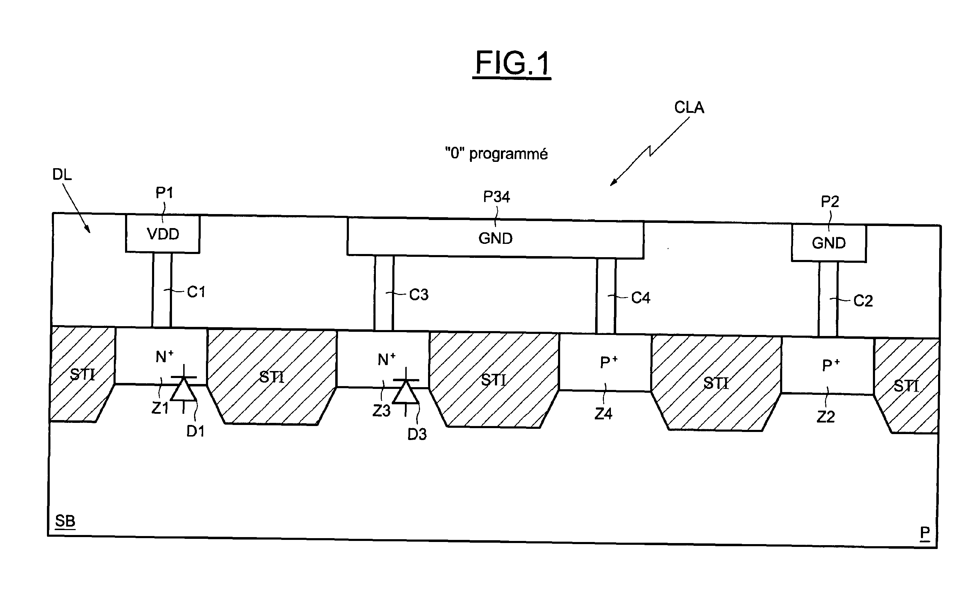

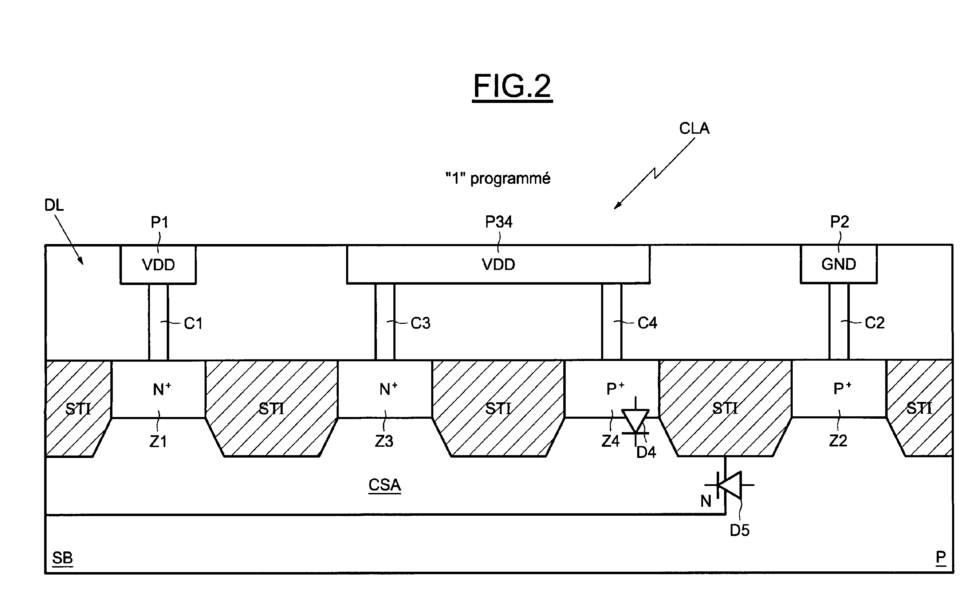

Sur les figures 1 et 2, la référence CLA désigne une cellule semi-conductrice destinée à stocker une information binaire (ou bit) capable de prendre deux valeurs logiques « 0 » et « 1 » par exemple.

La cellule semi-conductrice CLA comporte dans l'exemple décrit, au sein d'un substrat SB ayant le type de conductivité P, quatre zones actives Z1-Z4 mutuellement isolées latéralement par des zones d'isolation STI, par exemple des zones d'isolation du type « tranchée peu profonde ».

Le substrat P peut être le substrat de la plaquette semi-conductrice elle-même ou bien par exemple un caisson P dans une technologie triple caisson (triple well) bien connue de l'homme du métier.

Dans l'exemple décrit sur les figures 1 et 2, la première zone active Z1 est une zone dopée N⁺. La deuxième zone active Z2 est une zone dopée P⁺. La troisième zone active Z3 est une zone dopée N⁺ et la quatrième zone active Z4 est une zone dopée P⁺.

Sur chacune des zones actives Z1-Z4, est connecté de façon classique et connue en soi, un contact C1-C4, par exemple en tungstène.

Ces contacts relient les zone actives au niveau de métallisation M1 du circuit intégré.

Plus précisément, le contact C1 relie la zone active Z1 à une piste métallique P1 tandis que le contact C2 relie la deuxième zone active Z2 à une piste P2. Les contacts C3 et C4 relient les troisième et quatrième zones actives Z3 et Z4 à une piste P34 formant une connexion de raccordement électriquement conductrice.

Un ou éventuellement plusieurs matériaux diélectriques différents référencés de façon commune par la référence DL, isolent électriquement les contacts et les différentes pistes du niveau de métallisation M1.

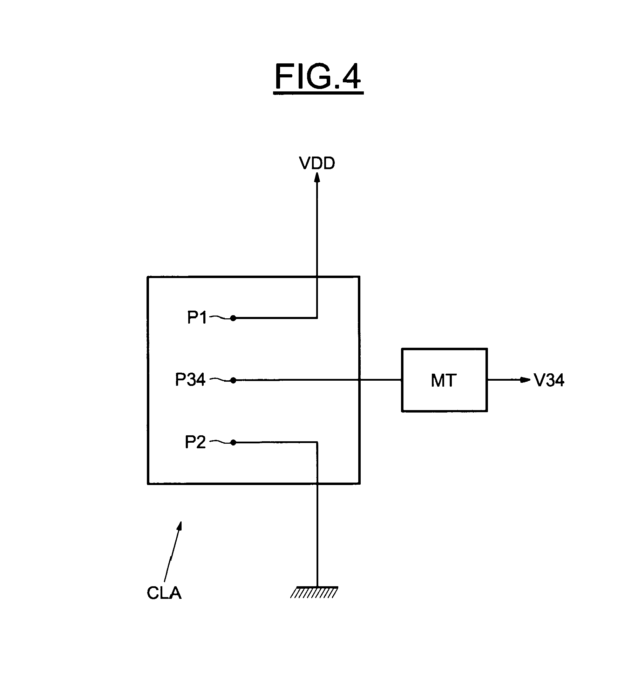

Les différentes pistes P1, P34 et P2 sont reliées de façon classique et connue en soi, à des contacts situés à l'extérieur du circuit intégré par des via et/ou d'autres pistes métalliques situées à des niveaux supérieurs du circuit intégré. De ce fait, comme illustré sur la figure 4 de façon très schématique, il est possible d'appliquer sur la piste P1, et par conséquent sur la première zone active Z1 une première tension, par exemple une tension d'alimentation VDD pouvant varier de 5 volts à 1 volt, et d'appliquer sur la piste P2, et par conséquent sur la deuxième zone active Z2, une deuxième tension, par exemple la masse.

Par ailleurs, comme on le verra plus en détails ci-après, la valeur logique du bit qui sera stocké dans la cellule CLA pourra être déterminée en mesurant la tension V34 présente sur la piste métallique P34. Cette lecture peut se faire par tout moyen de mesure MT connu en soi. Cette tension peut soit être égale à la tension d'alimentation VDD, indiquant une valeur logique « 1 », soit être égale à la masse, indiquant une valeur logique « 0 ».

La différence entre l'agencement structurel de la figure 1 et celui de la figure 2 réside dans le fait qu'il est prévu, sur la figure 2, un caisson CSA, disposé dans la région de substrat SB et ayant des interfaces avec la première zone active Z1, la troisième zone active Z3 et la quatrième zone active Z4. Ce caisson a un type de conductivité opposé à celui de la région de substrat. Il est par conséquent dans cet exemple de type N, et appelé communément « caisson N » ou « NWell ».

Comme on va le voir maintenant, la présence ou non de ce caisson CSA va permettre de conditionner la valeur logique « 0 » ou « 1 » du bit stocké dans la cellule CLA.

Plus précisément, si l'on veut programmer la cellule CLA avec une première valeur logique, par exemple un « 0 » logique, on n'implantera pas le caisson CSA (figure 1).

De ce fait, la jonction PN entre la première zone active Z1 et la région de substrat SB forme une diode D1 dont la cathode est tournée vers la zone Z1 et l'anode vers le substrat SB. Il en est de même en ce qui concerne la diode D3 résultant de la jonction PN formée entre la troisième zone active Z3 et la région de substrat P.

Ainsi, si, lors de la lecture de cette cellule CLA, on applique la tension VDD sur la première zone active Z1 et la masse sur la deuxième zone active Z2, la quatrième zone active Z4 est alors électriquement reliée à la masse GND via la région de substrat SB.

Par ailleurs, puisque le substrat SB est polarisé à la masse par l'intermédiaire de la zone active Z2, que la première zone active Z1 est polarisée à VDD et que la diode D1 est bloquée, la quatrième zone active Z4 est par conséquent électriquement isolée de la tension d'alimentation VDD.

En ce qui concerne la diode D3, elle voit la masse à ces deux bornes. Elle est par conséquent également bloquée.

En conclusion, la piste P34 est portée à la masse GND, ce qui est représentatif dans l'exemple décrit ici de la programmation d'un zéro logique.

Ainsi, dans l'exemple de la figure 1, la cellule comporte des moyens semi-conducteurs de liaison électrique, internes au substrat, agencés de façon à relier électriquement la quatrième zone active Z4 à la deuxième zone active Z2. Ces moyens semi-conducteurs de liaison électrique comportent ici la région de substrat SB.

Par ailleurs, la cellule comporte des moyens semi-conducteurs d'isolation électrique, internes au substrat, agencés de façon à isoler électriquement la zone active Z3 et la zone active Z4 de la première zone active Z1. Ces moyens semi-conducteurs d'isolation électrique comportent ici essentiellement la diode D1 bloquée formée par la jonction N⁺/P entre la zone Z1 et la région de substrat P.

Lorsqu'on veut programmer la cellule CLA avec une deuxième valeur logique, par exemple un « 1 » logique, on implante alors le caisson CSA (figure 2).

Dans ce cas, lors de l'application de la tension VDD sur la première zone active Z1 et de la masse sur la deuxième zone active Z2, la métallisation P34 est alors portée au potentiel VDD par l'intermédiaire de la première zone active Z1, du caisson CSA et de la troisième zone active Z3. Par ailleurs, la jonction PN formée entre la région de substrat SB et le caisson CSA forme une diode D5 bloquée (polarisée en inverse) et isole de ce fait électriquement le caisson CSA de la deuxième zone active Z2 et donc de la masse GND.

La diode D4, formée par la jonction PN entre la quatrième zone active Z4 et le caisson CSA voit la tension VDD à ses deux bornes. Elle est par conséquent bloquée.

Ainsi, la présence du caisson CSA est représentative de la programmation d'un « 1 » logique qui va conférer lors de la lecture de la cellule CLA la tension d'alimentation VDD à la piste P34.

Dans cette programmation, les moyens semi-conducteurs de liaison électrique, internes au substrat, sont agencés de façon à relier électriquement la troisième zone active Z3 à la première zone active Z1. Ces moyens semi-conducteurs de liaison électrique comportent ici le caisson CSA.

Par ailleurs, les moyens semi-conducteurs d'isolation électrique, sont agencés de façon à isoler électriquement les troisième et quatrième zones actives Z3 et Z4 de la deuxième zone active Z2. Ces moyens d'isolation électrique comportent ici essentiellement la diode D5 résultant de la jonction PN formée entre la région de substrat SB et le caisson CSA.

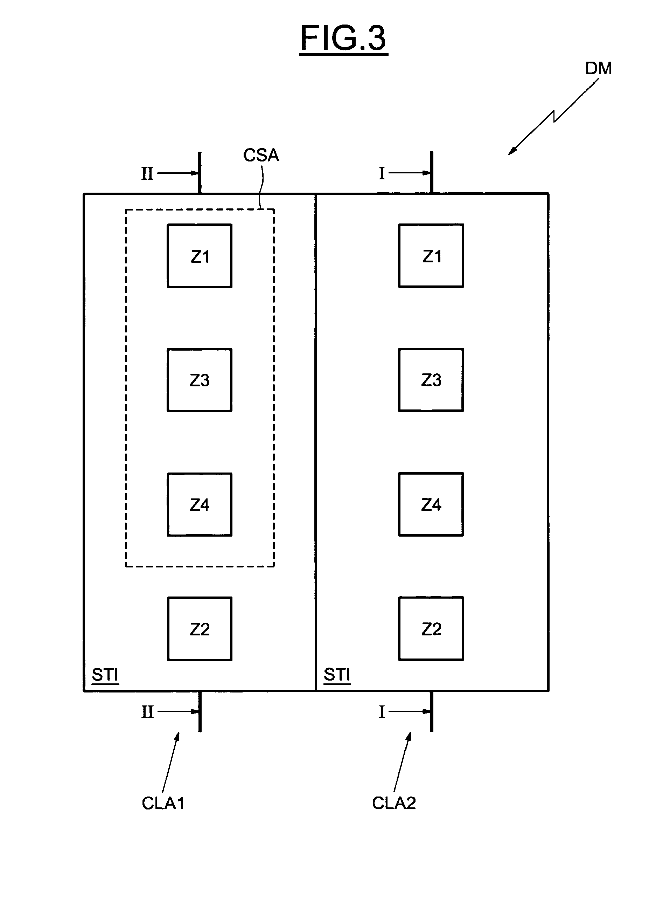

Les figures 1 et 2 sont en fait des coupes partielles selon les lignes I-I et II-II de la figure 3. Cette figure 3 représente un dispositif de mémoire DM selon l'invention comportant un ensemble de cellules semi-conductrices, ici deux cellules semi-conductrices à des fins de simplification. Le dispositif de mémoire DM comporte, sur la partie gauche de la figure 3 une cellule CLA1 comportant le caisson CSA tandis que la cellule CLA2 (partie droite de la figure 3) ne comporte pas le caisson CSA.

Par conséquent, le dispositif de mémoire DM de la figure 3 stocke les deux informations binaires « 1,0 ».

Il convient de noter que sur la figure 3, n'ont pas été représentés à des fins de simplification les contacts et pistes métalliques C1-C4 et P1, P2, P34.

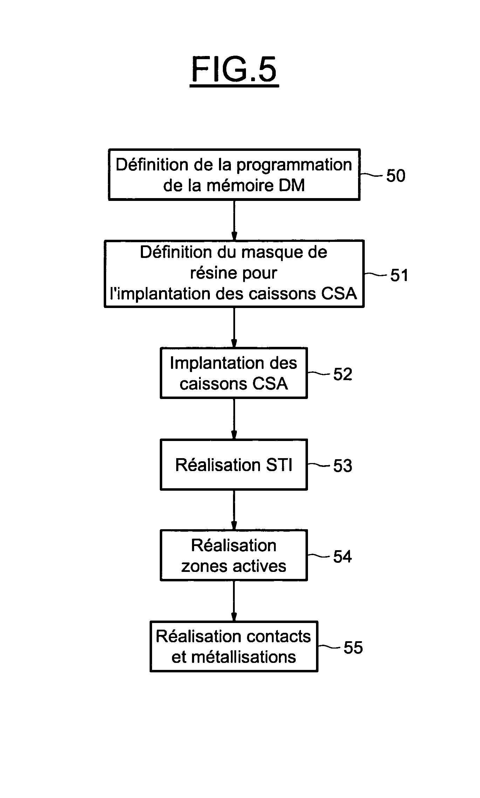

On va maintenant décrire en se référant plus particulièrement à la figure 5, un mode de programmation d'un dispositif de mémoire DM incorporant l'ensemble de cellules semi-conductrices du type de celles illustrées sur les figures 1 et 2.

On définit tout d'abord dans une étape 50, la programmation de la mémoire DM. En d'autre termes, on définit les valeurs logiques 0 et 1 des différents bits destinés à être programmés dans les différentes cellules de la mémoire.

Puis, on dépose sur la région de substrat SB une couche de résine. Puis, on ménage dans cette résine, de façon classique et connue en soi, des orifices correspondant aux emplacements des caissons éventuels CSA. La couche de résine, perforée par ces orifices, définit alors le masque d'implantation pour les caissons CSA (étape 51).

Plusieurs options sont possibles pour élaborer ce masque d'implantation.

Une première option consiste à définir les emplacements des orifices du masque de résine en utilisant une technique de photolithographie. Plus précisément, à l'aide d'un masque de photolithographie, on insole les parties de la résine correspondant aux futurs orifices puis on grave la résine ainsi insolée de façon à former les orifices.

Cette option rend la programmation « figée » en ce sens qu'il est nécessaire de développer un masque spécifique par programmation de mémoire.

Une autre option consiste à insoler la couche de résine aux endroits appropriés en utilisant une technique classique connue en soi à savoir une insolation par faisceaux d'électrons. Cette option rend la programmation totalement flexible car on modifie les impacts du faisceau d'électrons sur la résine à la demande, c'est-à-dire en fonction de la programmation effective souhaitée pour la mémoire.

Il est également possible d'effectuer un mixage de ces deux options. En d'autres termes, on peut définir le masque d'implantation des caissons en utilisant, pour une partie de la mémoire, une technique de photolithographie, et pour l'autre partie de la mémoire une technique d'insolation par faisceaux d'électrons.

Une fois le masque d'implantation des caissons réalisé, on procède à l'implantation de type N à travers ce masque de façon à réaliser de façon simultanée tous les caissons CSA de la mémoire DM (étape 52).

Puis, on réalise de façon classique et connue en soi, les zones d'isolation latérales STI (étape 53).

La réalisation des zones actives Z1-Z4 est effectuée également de façon classique (étape 54) par implantation.

Enfin, on réalise, toujours de façon classique et connue en soi, les contacts et métallisations du circuit intégré (étape 55).

On se réfère maintenant plus particulièrement aux fi gures 6 à 9 pour décrire une autre variante de l'invention.

Dans cette variante, la programmation d'un « 0 » ou d'un « 1 » logiques s'effectue non pas par l'implantation ou non d' un caisson dans la région de substrat SB mais par le choix du type de conductivité (N+ ou P+) des troisième et quatrième régions actives Z3 et Z4.

Plus précisément, dans cette variante, quelle que soit la valeur logique programmée dans la cellule CLB, celle-ci comporte un caisson CSB de type N disposé dans la région de substrat SB et ayant une interface avec la première zone active Z1 et la troisième zone active Z3.

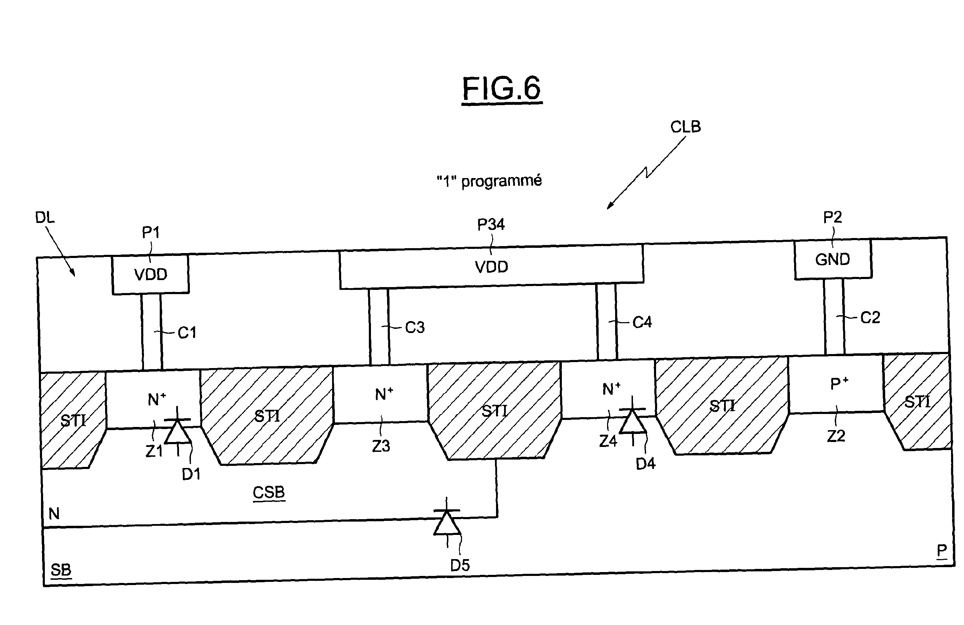

Comme illustré sur la figure 6, lorsque l'on veut programmer un « 1 » logique dans la cellule CLB, les troisième et quatrième zones actives Z3 et Z4 sont alors des zones dopées N⁺ (ayant donc le type de conductivité N).

De ce fait, lorsqu'on applique, pour la lecture, la tension VDD sur la zone active Z1 et la masse GND sur la deuxième zone active Z2, la piste P34 est portée au potentiel VDD par l'intermédiaire de la première zone active Z1 du caisson CSB et de la troisième zone active Z3.

Par ailleurs, la première et la troisième zones actives Z1 et Z3 sont électriquement isolées de la deuxième zone active Z2 par la diode D5 polarisée en inverse et formée par la jonction PN entre le caisson CSB et la région de substrat SB.

De même, la quatrième zone active Z4 est électriquement isolée de la deuxième zone active Z2 par la diode bloquée D4 formée par la jonction PN entre cette quatrième zone active Z4 et la région de substrat SB.

Ainsi, dans cette variante, les moyens semi-conducteurs de liaison électrique, internes au substrat, sont agencés de façon à relier électriquement la troisième zone active Z3 à la première zone active Z1 et comportent ici le caisson CSB.

Par ailleurs, les moyens semi-conducteurs d'isolation électrique, internes au substrat, sont agencés de façon à isoler électriquement la troisième zone active Z3 et la quatrième zone active Z4 de la deuxième zone active Z2. Ils comportent ici la diode bloquée D5 formée entre le caisson CSB et le substrat SB et la diode D4 formée entre la quatrième zone active Z4 et le substrat SB.

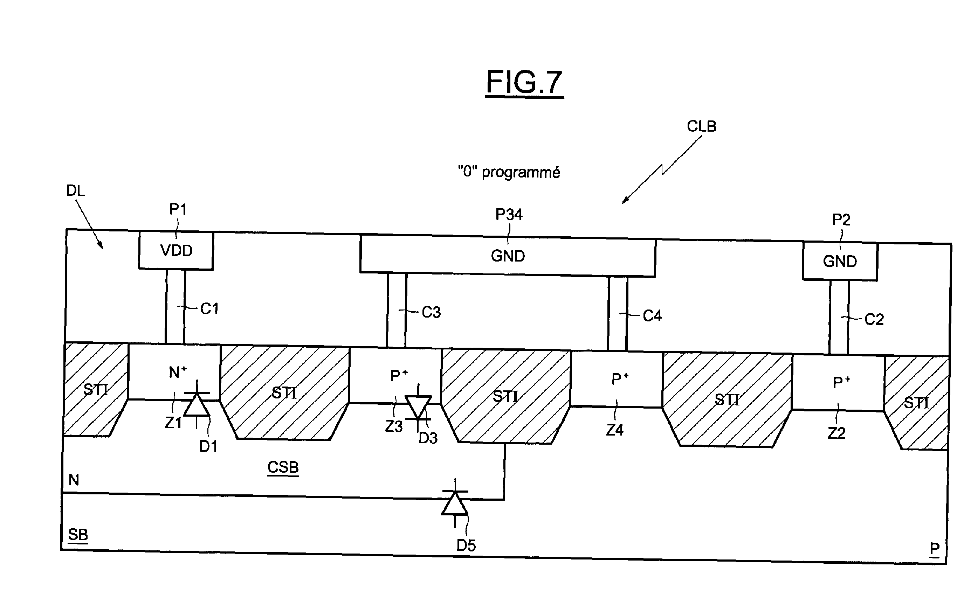

Lorsqu'on veut programmer un « 0 » logique, les troisième et quatrième zones actives Z3 et Z4 sont cette fois-ci des zones actives dopées P⁺ (figure 7).

De ce fait, lorsque, lors de la lecture, on applique la tension VDD sur la première zone active Z1 et la masse sur la deuxième zone active Z2, la métallisation P34 est portée à la masse par l'intermédiaire de la deuxième zone active Z2 de la région de substrat SB et de la quatrième zone active Z4.

Par ailleurs, la troisième zone active Z3 est électriquement isolée de la première zone Z1 par la diode bloquée D3 formée par la jonction P⁺/N entre la troisième zone active et le caisson CSB.

De même, la quatrième zone active Z4, et également la deuxième zone active Z2 sont électriquement isolées de la première zone active Z1 par la diode D5 formée entre le caisson CSB et la région de substrat SB.

Ainsi, ici, les moyens semi-conducteurs de liaison électrique, internes au substrat, sont agencés de façon à relier électriquement la quatrième zone active Z4 à la deuxième zone active Z2, et comportent la région de substrat SB. Par ailleurs, les moyens d'isolation électrique, internes au substrat, sont ici agencés de façon à isoler électriquement les troisième et quatrième zones actives de la première zone active Z1. Ils comportent ici les diodes D3 et D5.

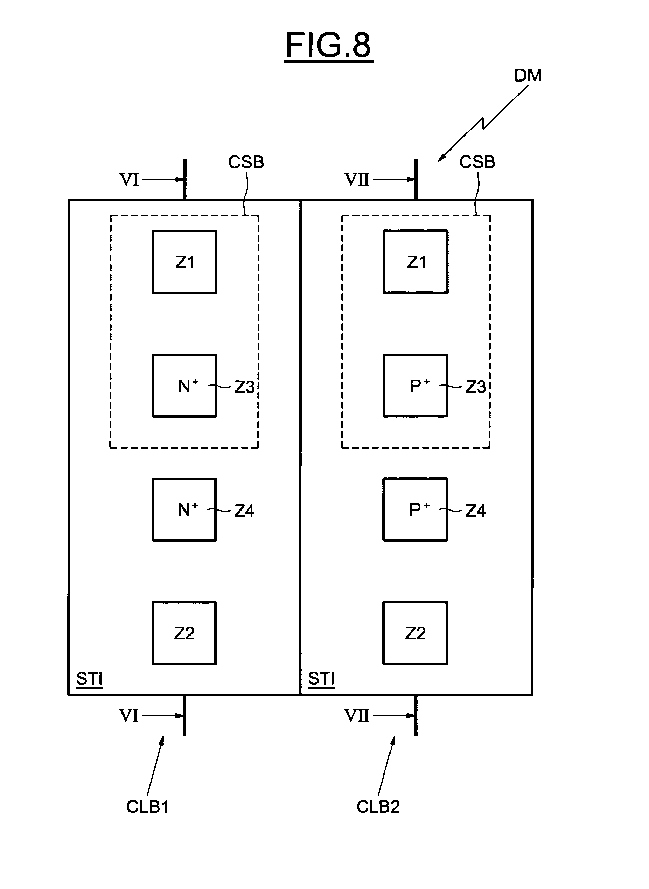

Les figures 6 et 7 sont en fait des coupes partielles selon les lignes VI-VI et VII-VII de la figure 8 sur laquelle, comme sur la figure 3, on n'a pas représenté les différents contacts et métallisations des cellules.

Sur cette figure 8, la référence CLB1 désigne une cellule programmée avec un « 1 » logique tandis que la référence CLB2 désigne une cellule programmée avec un « 0 » logique.

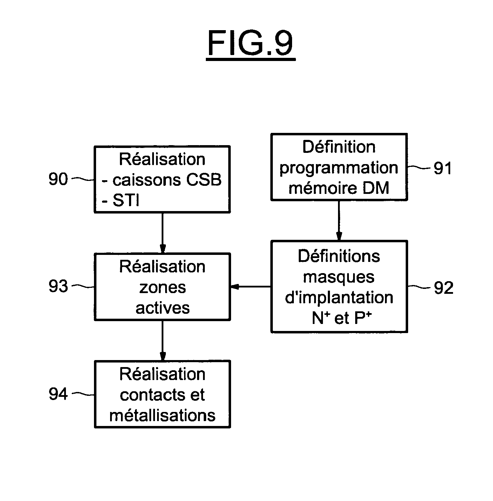

On se réfère maintenant plus particulièrement à la figure 9 pour décrire les principales étapes d'un mode de programmation d'un dispositif de mémoire tel que celui illustré sur la figure 8.

On procède tout d'abord (étape 90) à la réalisation classique et connue en soi des différents caissons CSB et des zones d'isolation SDI.

Par ailleurs, après avoir défini la programmation de la mémoire DM, on définit deux masques d'implantation N⁺ et P⁺ (étape 92).

Là encore, la définition de ces masques d'implantation N⁺ et P⁺ peut s'effectuer par une technique de photolithographie et/ou par une technique d'insolation par faisceaux d'électrons comme expliqué ci-avant.

Une fois ces deux masques d'implantation définis, on réalise les zones actives. Précisément, on réalise tout d'abord les zones actives N⁺ puis les zones actives P⁺, ou inversement (étape 93).

Enfin, on réalise de façon classique et connue en soi, les contacts et métallisations (étape 94).

Les deux modes de réalisation de la mémoire qui viennent d'être décrits présentent tous les deux une bonne densité. Plus précisément, les deux modes de réalisation offrent une densité de 3,5 micron² par bit, en technologie CMOS 0,13 microns.

Ils offrent également tous les deux la possibilité d'offrir une mémoire possédant un état vierge, (correspondant par exemple à l'état logique 0), ce qui permet de modifier la programmation éventuellement de façon flexible à la demande de l'utilisateur, en jouant sur les implantations de caissons ou de zones actives.

Enfin, les modes de réalisation des figures 1, 2 et 3 présentent un faible coût car ils nécessitent un seul niveau de masquage pour la programmation. Le mode de réalisation des figures 6, 7 et 8 présente quant à lui un coût plus élevé, mais cependant toujours réduit, car il nécessite deux niveaux de masquage (N⁺ et P⁺).

## Revendications

1. Dispositif de mémoire comprenant au moins une cellule stockant une information binaire et comportant au sein d'une région de substrat semi-conductrice (SB) quatre zones actives (Z1-Z4) mutuellement isolées latéralement, la première zone active (Z1) étant destinée à être reliée à une première tension, la deuxième zone active (Z2), d'un type de conductivité opposé à celui de la première zone active, étant destinée à être reliée à une deuxième tension, les troisième (Z3) et quatrième (Z4) zones actives étant mutuellement reliées par une connexion de raccordement (P34) électriquement conductrice et extérieure au substrat, des moyens semi-conducteurs de liaison électrique, internes au substrat, agencés de façon à relier électriquement au moins l'une ou l'autre des troisième et quatrième zones actives à la première zone active ou bien à la deuxième zone active selon de la valeur logique de ladite information binaire, et des moyens semi-conducteurs d'isolation électrique, internes au substrat, agencés de façon à isoler électriquement les troisième et quatrième zones actives de la deuxième zone active, ou bien de la première zone active, respectivement.

2. Dispositif selon la revendication 1, **caractérisé par le fait que** lesdits moyens semi-conducteurs d'isolation électrique comportent des jonctions PN formant des diodes bloquées (D1, D5, D4) entre au moins une zone active et la région de substrat, ou entre au moins une zone active et un caisson semi-conducteur situé dans la région de substrat, ayant un type de conductivité opposé à celui de la région de substrat, et ayant une interface avec au moins cette zone active, et/ou entre ledit caisson et la région de substrat, et **par le fait que** les moyens semi-conducteurs de liaison électriques comportent la région de substrat ou ledit caisson.

3. Dispositif selon la revendication 2, **caractérisé par le fait que** les troisième et quatrième zones actives (Z3, Z4) ont respectivement deux types de conductivité opposés, et **par le fait que** la cellule comporte ledit caisson (CSA) ayant des interfaces avec les troisième et quatrième zones actives et avec celle des première ou deuxième zones actives ayant le même type de conductivité que celui du caisson, ou bien ne comporte pas un tel caisson, selon la valeur logique de ladite information binaire.

4. Dispositif selon la revendication 2 ou 3, **caractérisé par le fait que** les moyens semi-conducteurs d'isolation électrique comportent des jonctions PN (D1, D4, D5) formées entre la région de substrat et les zones actives ayant un type de conductivité opposé à celui de la région de substrat, ou bien entre la région de substrat et le caisson semi-conducteur ayant des interfaces avec les troisième et quatrième zones actives et avec celle des première ou deuxième zones actives ayant le même type de conductivité que celui du caisson, et **par le fait que** les moyens semi-conducteurs de liaison électriques comportent la région de substrat ou bien le caisson.

5. Dispositif selon la revendication 3 ou 4, **caractérisé par le fait que** la première zone active (Z1) est de type de conductivité N tandis que la deuxième zone (Z2) active est de type de conductivité P, et **par le fait que** l'éventuel caisson (CSA) a un type de conductivité N.

6. Dispositif selon la revendication 2, **caractérisé par le fait que** les troisième et quatrième zones actives (Z3, Z4) ont toutes les deux le même type de conductivité, **par le fait que** ledit caisson (CSB) possède une interface avec la troisième zone active et avec celle des première ou deuxième zones actives ayant le même type de conductivité que celui du caisson, et **par le fait que** le type de conductivité des troisième et quatrième zones actives (Z3, Z4) est fonction de la valeur logique de ladite information binaire.

7. Dispositif selon la revendication 2 ou 6, **caractérisé par le fait que** les troisième et quatrième zones actives (Z3, Z4) ont toutes les deux le même type de conductivité, **par le fait que** ledit caisson (CSB) possède une interface avec la troisième zone active et avec celle des première ou deuxième zones actives ayant le même type de conductivité que celui du caisson, **par le fait que** les moyens semi-conducteurs d'isolation électrique comportent une jonction PN formant une diode bloquée entre le caisson (CSB) et la région de substrat (SB) et une jonction PN formant une diode bloquée entre la troisième zone active (Z3) et le caisson (CSB) ou entre la quatrième zone active (Z4) et la région de substrat (SB) selon la valeur la valeur logique de l'information binaire, et **par le fait que** les moyens semi-conducteurs de liaison électrique comportent la région de substrat ou ledit caisson, respectivement.

8. Dispositif selon la revendication 6 ou 7, **caractérisé par le fait que** la première zone active est de type de conductivité N tandis que la deuxième zone active est de type de conductivité P, **par le fait que** le caisson a un type de conductivité N, et **par le fait que** le type de conductivité des troisième et quatrième zones actives est de type N ou P selon la valeur logique de l'information binaire.

9. Dispositif selon l'une des revendications précédentes, **caractérisé par le fait que** la première tension est une tension d'alimentation (VDD) tandis que la deuxième tension est la masse (GND).

10. Dispositif selon l'une des revendications précédentes, **caractérisé par le fait qu'**il comporte un ensemble de cellules stockant un ensemble d'informations binaires.

11. Dispositif selon l'une des revendications précédentes, **caractérisé par le fait qu'**il comprend des moyens de lecture de chaque cellule, ces moyens de lecture comportant une première source de tension connectée sur la première zone active, une deuxième source de tension connectée sur la deuxième zone active, et des moyens de mesure (MT) de la tension présente sur ladite connexion de raccordement de ladite cellule.

12. Procédé de lecture de la valeur logique d'une information binaire contenue dans une cellule d'un dispositif de mémoire selon l'une des revendications précédentes, **caractérisé par le fait qu'**on applique la première tension (VDD) sur ladite première zone active (Z1), on applique la deuxième tension (GND) sur ladite deuxième zone active (Z2), et on mesure la tension (V34) sur ladite connexion de raccordement (P34).

13. Procédé de programmation d'une information binaire dans une cellule comportant au sein d'une région semi-conductrice de substrat quatre zones actives (Z1-Z4) mutuellement isolées latéralement, la première zone active étant destinée à être reliée à une première tension (VDD), la deuxième zone active, d'un type de conductivité opposé à celui de la première zone active, étant destinée à être reliée à une deuxième tension (GND), les troisième et quatrième zones actives (Z3-Z4) étant mutuellement reliées par une connexion de raccordement (P34) électriquement conductrice et extérieure au substrat, procédé dans lequel on définit la valeur de l'information binaire par une implantation de type choisi dans une partie (CSA) prédéterminée de la région de substrat (SB) ou dans les troisième et quatrième zones actives (Z3-Z4).

14. Procédé selon la revendication 13, **caractérisé par le fait que** les troisième et quatrième zones actives ont des types de conductivité opposés, et **par le fait qu'**on définit la valeur logique de l'information binaire en implantant ou non dans la région de substrat un caisson semi-conducteur (CSA) ayant un type de conductivité opposé à celui de la région de substrat, et ayant des interfaces avec les troisième et quatrième zones actives et avec celle des première ou deuxième zones actives ayant le même type de conductivité que celui du caisson.

15. Procédé selon la revendication 14, **caractérisé par le fait que** la première zone active est de type de conductivité N tandis que la deuxième zone active est de type de conductivité P, et **par le fait que** l'éventuel caisson a un type de conductivité N.

16. Procédé selon la revendication 13, **caractérisé par le fait que** les troisième et quatrième zones actives ont toutes les deux le même type de conductivité, **par le fait qu'**on implante dans la région de substrat un caisson semi-conducteur ayant un type de conductivité opposé à celui de la région de substrat, et ayant une interface avec la troisième zone active et avec celle des première ou deuxième zones actives ayant le même type de conductivité que celui du caisson, et **par le fait qu'**on définit la valeur logique de ladite information binaire en choisissant le type d'implantation dans les troisième et quatrième zones actives (Z3-Z4).

17. Procédé selon la revendication 16, **caractérisé par le fait que** la première zone active est de type de conductivité N tandis que la deuxième zone active est de type de conductivité P, **par le fait que** le caisson a un type de conductivité N, et **par le fait que** le type de conductivité des troisième et quatrième zones actives est de type N ou P selon la valeur logique de l'information binaire.

18. Procédé de programmation des valeurs d'un ensemble informations binaires respectivement contenues dans un ensemble de cellules semi-conductrices, **caractérisé par le fait qu'**on programme chaque cellule avec un procédé selon l'une des revendications 13 à 17.

19. Procédé selon la revendication 18 prise en combinaison avec la revendication 14 ou 15, **caractérisé par le fait qu'**on définit (51) les emplacements d'implantation des caissons éventuels par des orifices dans un masque d'implantation, par exemple en résine et **par le fait qu'**on implante simultanément (52) tous les caissons à travers les orifices du masque d'implantation.

20. Procédé selon la revendication 18 ou 19 prise en combinaison avec la revendication 16 ou 17, **caractérisé par le fait qu'**on définit (92) un masque d'implantation de type N+ et un masque d'implantation de type P+, et **par le fait qu'**on implante simultanément (93) toutes les zones actives de toutes les cellules à travers les orifices des masques d'implantation en utilisant successivement les deux masques d'implantation.

21. Procédé selon la revendication 19 ou 20, **caractérisé par le fait qu'**on définit les emplacements des orifices du ou des masques d'implantation par un masque de photolithographie et/ou par faisceau d'électrons.
